# EUROPEAN PATENT SPECIFICATION

(11) **EP 0 514 615 B1**
(45) Date of publication and mention of the grant of the patent: **03.05.1995**
(21) Application number: 91830215.9
(22) Date of filing: 23.05.1991
(51) Int. Cl.: H01L 23/051, H01L 23/522, H01L 23/525

(54) **Electronic power device realized by a series of elementary semi-conductor components connected in parallel and related manufacturing process**
Elektronische Leistungsanordnung realisiert durch eine Reihe elementarer Halbleiterbauelemente in Parallelverbindung und verwandtes Herstellungsverfahren
Dispositif électronique de puissance réalisé par une série de composants semiconducteurs connectés en parallèle et procédé de fabrication apparenté

(43) Date of publication of application: 25.11.1992
(73) Proprietor: SGS-THOMSON MICROELECTRONICS s.r.l., 20041 Agrate Brianza (Milano) (IT); ANSALDO TRASPORTI S.p.A., I-80147 Napoli (IT)
(72) Inventor: Ferla, Giuseppe, I-95126 Catania CT (IT); Ronsisvalle, Cesare, I-95126 Catania CT (IT); Zani, Pier Enrico, I-16137 Genova GE (IT)
(74) Representative: Arena, Giovanni

(56) References cited:
- EP-A- 0 306 620
- EP-A- 0 326 780
- EP-A- 0 421 344
- GB-A- 2 151 079
- US-A- 4 402 004

## Description

The present invention relates to an electronic power device realized by a series of elementary semiconductor components connected in parallel and the related manufacturing process.

Electronic power devices of the semiconductor type are commonly provided either with a single semiconductor component having a more or less large area, e.g. a thyristor, or with a number of physically separate semiconductor components mounted in parallel on insulated modular units contained in a single package.

Electronic power devices provided with a single component have limits as concerns the limited value of deliverable power or, if they have high power with output current between 1000 A and 3000 A, as concerns the lesser piloting ease and limited switching speed. A high power device with a single component is the one known in trade by the name 'Press Pack'.

Electronic power devices with a number of physically separate components have disadvantages connected with the greater complexity of assembly procedures and, in higher power devices, considerably greater space occupied compared with that of devices of equal power having a single component.

From EP-A-0 326 780 a power transistor is known with a number of bipolar junction transistors connected in parallel and monolithically integrated. In order to avoid possible defective operation of the transistor the contact links from each device collector to a common collector line is provided with a fusible portion. Even the base may be provided with a fusible link portion. When a transistor becomes defective the fusible link portion burns out and the transistor becomes isolated.

The purpose of the present invention is the embodiment of power devices and in particular very high power devices free from the aforementioned disadvantages.

These and other purposes are achieved by a device and manufacturing process as described and characterized in the claims set forth below.

The features of the present invention will be more evident by the following description and the annexed drawings relevant to possible embodiment examples of nonlimitative value. In the drawings:
- FIG.1: shows a cross section view of an embodiment of a device in accordance with the present invention,
- FIG.2: shows an exploded perspective view of the device of FIG. 1,
- FIG.3: shows a top view of the silicon slice of FIGS. 1 and 2,
- FIG.4: shows a bottom view of the contact washer of FIGS. 1 and 2,
- FIG.5: shows a cross section of the above contact washer,
- FIG.6: shows an enlarged top view of a metallic track of the network of metallic tracks on the top of the silicon slice of FIG. 3, and
- FIG.7: shows a circuit equivalent to an elementary power device of the MCT type.

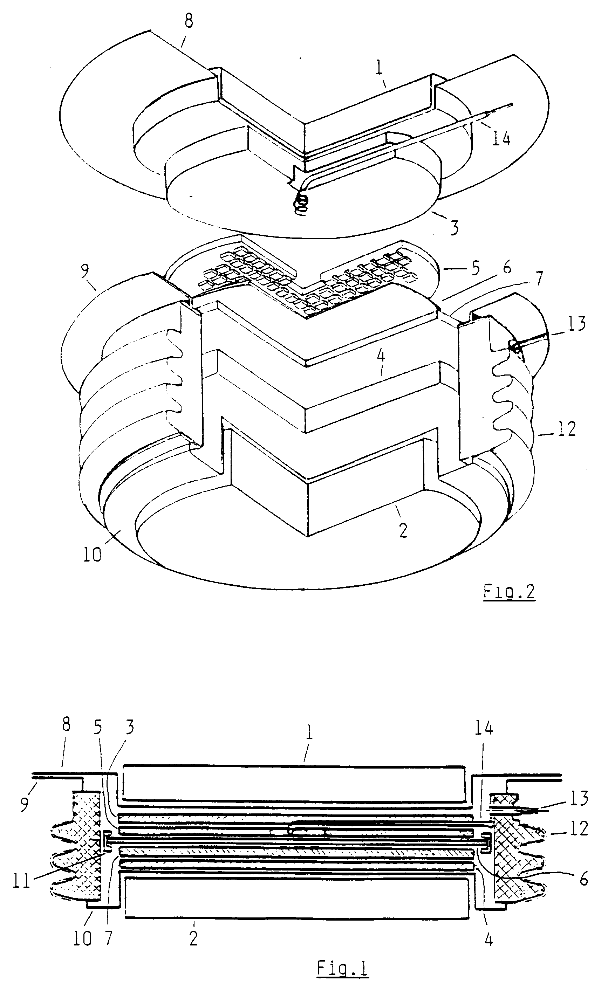

FIGS. 1 and 2 show two views, a cross section view and an exploded perspective view respectively, of a power device in accordance with the present invention. The meaning of the various parts therein is as follows:
- 1 and 2:: nickel plated copper plates constituting the cathode and the anode respectively of the device;
- 3 and 4:: molibdenum or tungsten plate;
- 5:: contact washer made of silver plated copper or silver or molibdenum;
- 6:: silicon slice;
- 7:: contact disk made of silver plated copper or silver or molibdenum;
- 8, 9 and 10:: flange of nickel plated copper;
- 11:: plastic washer for positioning the silicon slice in the container;
- 12:: porcelain container body;
- 13:: duct and terminal of the control electrode;
- 14:: filiform metallic element for lead-in of the control signal, with the end part consisting of a spiral spring.

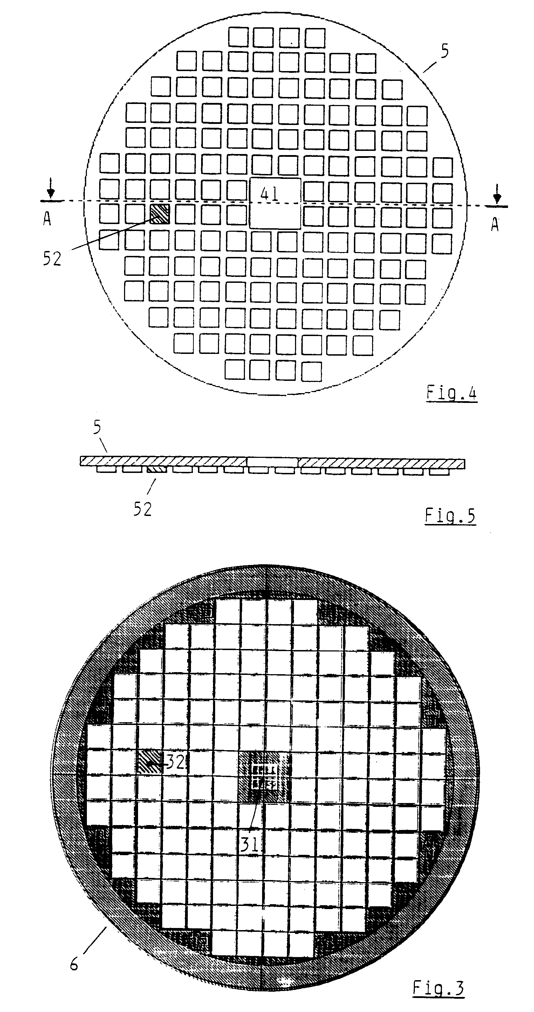

Fig.3 shows a top view of the silicon slice 6 of FIGS. 1 and 2, having a diameter of 5 inches. It shows a lattice made up of 15 vertical lines and 15 horizontal lines delimiting all together 144 blank quadrangular areas. These areas represent the same number of elementary cathodic metallizations, i.e. metallized areas, e.g. of aluminium, of the top surface of the slice, insulated from one another, each delimiting an underlying portion of the slice, i.e. a chip, wherein is provided an elementary semiconductor component whose cathode region is in contact with the top elementary metallized area.

The underlying side of the slice (not shown) is entirely metallized and constitutes the common anodic electrode to which lead the anodes of the individual elementary components.

The fifteen vertical and horizontal lines of FIG. 3 represent a series of metallic tracks of aluminium (bus) running beside the above mentioned elementary cathodic metallizations and insulated therefrom, having the function of lead-in tracks for distributing the control signal to the control electrodes of the various elementary power components. Said metallization tracks have interconnection points at each crossing and lead to a common quadrangular metallization area 31 (control pad) in the centre of the top surface of the slice, an area which acts as a common control terminal to which lead all the control electrodes of the various elementary semiconductor components.

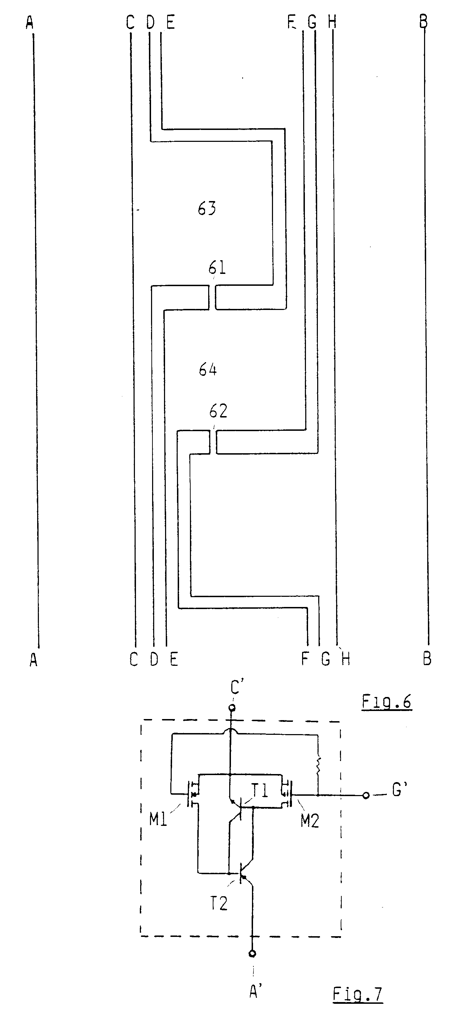

FIG. 6 shows an enlarged scaleless view of said metallic tracks in a section intermediate between two successive vertical crossings. The parts thereof represent:
- A:: righthand border line of the cathodic metallization of the lefthand chip;
- B:: lefthand border line of the cathodic metallization of the righthand chip;
- EF:: lines delimiting inside them a vertical central bus running between the above borders and interconnected at the top and bottom crossings with other horizontal central buses exactly like it;
- CD:: lines delimiting inside them a metallic track acting as a side control bus for the lefthand chip, running along the 4 sides of the cathodic metallization of the chip and insulated therefrom; it is also insulated from the central buses running around the chip, except at four connection points, one for each side of the chip; for the righthand side of the lefthand chip this connection point at the central bus is represented by a metallic jumper 61 made of the same metallic film the tracks are made of;
- GH:: the same remarks as for the CD lines apply but for the righthand chip; the GH lines delimit inside them a metallic track acting as a side control bus for the righthand chip, running along the 4 sides of the cathodic metallization of the chip and insulated therefrom; it is also insulated from the central buses running around the chip, except at four connection points, one for each side of the chip; for the lefthand side of the righthand chip this connection point to the central bus is represented by the metallic bridge 62 which is also made of the same metallic film as the tracks.

The description of a section of metallic tracks intermediate between two successive vertical crossings applies naturally also, mutatis mutandis, to an intermediate section between two successive horizontal crossings.

The side control bus of each chip is interconnected, in a manner not shown in the figures but apparent to those skilled in the art, with the control electrode of the elementary component provided in the chip. Said elementary component can be of the MOS type (Power MOS, IGBT, MCT) or bipolar (SCR, GTO, BJT). If an MCT (MOS Controlled Thyristor) component is used, of which FIG. 7 shows the equivalent electrical circuit (in this figure A′,G′ and C′ represent the anode, gate and cathode electrodes, T1 and T2 two bipolar transistors, M1 an N-channel MOS and M2 a P-channel MOS transistor), the control bus of each chip will be interconnected with the underlying polysilicon gate layer of the two P-channel and N-channel MOS in the MCT.

From the foregoing it is clear that the control electrode of each elementary component is electrically connected to the common control terminal (pad 31) through the side control buses of each chip, the associated points of connection to the central buses and the central buses themselves.

As shown in FIG. 4 in a bottom view and FIG. 5 in a cross section view along plane of cut A-A of FIG. 4, the contacting washer 5 has at the bottom a lattice of grooves reflecting the same arrangement as the lattice of metallization tracks on the top surface of the slice. These grooves divide the bottom side of the contacting washer in 144 quadrangular reliefs having the function of contacting the elemenary cathodic metallizations while avoiding contact with the central and side buses of the slice. To avoide this it is sufficient to size the width of the groove adequately. In the centre of the contacting washer there is a quadrangular opening 41 designed to allow passage of the terminal spring part of the lead-in wire 14 for the control signal.

Division of the metallization tracks of the slice in central and side buses, and the presence of connection points between the side and central buses take on significance in the light of the following considerations.

The case in which the elementary components provided in a silicon slice of the type shown in FIG. 3 will all be operational at the end of the manufacturing process is an entirely theoretical eventuality. In reality all the components in the slice must be subjected to acceptance testing at the end of the processing.

Normally, following this test, some components (chips) are defective and hence, in the present case, must be made electrically inactive. The structural characteristics indicated above for the device in accordance with the present invention serve advantageously for this purpose.

Let us assume for example that the chip 32 of FIG. 3 is defective upon inspection. In this case it will be made inactive by eliminating the connection points between each side bus and the adjacent central buses and also eliminating the contact of its cathodic metallization with the washer 5.

Elimination of the connection points is very easy. Supposing that the bus of FIG. 6 is on the righthand side of the chip 32, to eliminate the righthand connection point it is sufficient to circulate in the jumper 61, e.g. by applying two electrodes of opposite electric polarity on the two widened areas 63 and 64 of FIG. 6, a sufficiently strong current to cause fusion. The same applies for the other connection points of the side buses of the chip 32. It is thus seen that the above connection points between side and central buses also fulfill the useful function of fuses.

To eliminate the contact between the cathodic metallization of the chip 32 and the washer 5 there must be no corresponding quadrangular contact relief (52 in FIGS. 4 and 5) in the washer.

To achieve this there are two ways to proceed:
1) providing the washer 5 after the acceptance test of the chip and then using a photoetching mask of the washer which excludes the relief 52; or
2) providing before the acceptance test a washer 5 having all the contacting reliefs and then, after the chip test, mechanically removing, e.g. with a step cutter, the relief 52.

It will be very opportune also to put in place of the absent metallic relief 52 a thin layer of insulating material, e.g. a layer of mica fixed with bonding agent, designed to prevent any electrical discharges between the cathode and the anode of the defective power component during operation.

Once the defective chips have been deactivated as explained above, the device is ready for assembly. The silicon slice, the contacting washer, the contacting disk and the two molibdenum or tungsten disks are placed in the ceramic body 12 in accordance with the arrangement shown in FIGS. 1 and 2. Subsequently, in accordance with the known art for the "press pack" package, the device is closed and sealed permanently by welding the copper flanges in a pure nitrogen environment, nitrogen which at the end remains incorporated in the package.

When the device has been closed and the metallic plates 1 and 2 have been applied thereto, it is ready for installation. In the installed device the internal contacts (anode, cathode and gate) for connecting the internal components to the external user's circuit are provided by free pressure contacts. More specifically, the anode and cathode contacts consist of copper poles of "press pack" package which, when subjected to sufficient pressures, ensure the passage of thousands of amperes and dissipation of the heat generated in the power component, while the gate contact is ensured by the pressure exerted by the terminal spring of the wire 14 on the pad 31 in the centre of the slice, the wire 14 serving as connection with the outside through the duct 13 passing through the ceramic of the press pack capsule (FIGS. 1 and 2).

The advantages of the above described device are apparent. In particular the device make it possible:
- achieving switching speed and piloting ease typical of components of small power and, at the same time, occupying the reduced space characteristic of more powerful devices provided by a single component;
- minimizing the space occupied by the various elementary components placed in parallel by using the same slice on which they were provided;
- using a package already on the market (the press pack) having excellent heat dissipation characteristics;
- assemblying with extreme ease and speed, due to the specific structure of the contacting washer 5, the arrangement of the metallic gate tracks and the presence of connection points (fuses) betwen the central and side buses which allows fast and safe deactivation of defective components;
- providing power devices, especially MOS technology devices, with good yield.

Obviously numerous modifications, adaptations, variations and substitutions of elements with others functionally equivalent are possible to the preferred embodiments described above without departing from the scope of the following claims.

One such variation could for example concern the insulation provided between defective chips and the upper contacting washer, which could be ensured by a layer of insulation other than mica or even by the nitrogen atmosphere filling the package.

Another variation could concern the connection points between the side and central buses which could be provided in another way, e.g. with other kinds of fuses.

## Claims

1. A power semiconductor device comprising:
- an array of semiconductor component elements connected in parallel and formed in a single slice of semiconductor material having first and second major surfaces,
each said component element having an anode electrode, a cathode electrode and a control electrode,
- a metallic layer covering said first surface, said metallic layer being formed on said anode electrodes of the semiconductor component elements,
- an array of discrete cathode metallizations on said second surfaces, each one being formed on a respective cathode electrode of a component element;
- a first series of metallic tracks on said second surface, each track of said first series of metallic tracks running around the periphery of a respective cathode metallization whilst being insulated therefrom and in contact with the control electrode of the respective component element,
- a second series of interconnected metallic tracks on said second surface and having vertical and horizontal tracks in a mesh-like lattice interconnected at each crossing and arranged such that inside each mesh of said lattice is a respective discrete cathode metallization and the corresponding track of said first series of metallic tracks,
- a common control terminal metallization area (31) in the centre of the second surface of the slice, said second series of interconnected metallic tracks being electrically connected to said common control terminal metallization area,
each semiconductor component element having at least one fusible connection element (61, 62) associated therewith, said fusible connection element (61, 62) being provided on the second surface of the slice and connecting the respective track of said first series of metallization tracks with the respective adjacent track of said second series of interconnected metallic tracks.

2. Power semiconductor device according to claim 1 characterized in that said first series of metallic tracks and second series of interconnected metallic tracks have widened areas at the connection points with said fusible connection elements (61,62).

3. Power semiconductor device according to claim 1 characterized in that said fusible connection elements (61,62) consist of thin metallic tracks on the second surface of the slice.

4. Power semiconductor device device according to claim 1 characterized in that the device comprises defective component elements (32) and at each defective component element the first series of metallic tracks are completely insulated from the second series of interconnected metallic tracks.

5. An assembly of a power semiconductor device according to claim 1 and a metallic contact disk characterized by a metallic contact disk (5) contacting the second surface of the slice for its entire extension, having an opening facing said common control terminal metallisation area of the slice and also having on the surface contacting the slice a series of grooves corresponding to said first and second series of tracks so as to give an array of quadrangular relief portions one for each efficient semiconductor component element of the slice, each one contacting the corresponding cathode metallization of one said component element.

6. Assembly according to claim 5 characterized in that opposite each defective component element (32) of the slice said quadrangular relief portions are missing.

7. Assembly according to claim 6 characterized in that at each defective component element of the slice the cathode metallization is insulated from the neighbouring metallic contact disk (5) by a layer of insulating material.

8. Assembly according to claim 7 characterized in that said layer of insulating material consists of mica.

9. Assembly according to claim 5 characterized in that said metallic contact disk (5) is silver plated copper or silver or molybdenum.

10. Packaged power semiconductor device comprising the assembly of claim 5 or 9 characterized in that said slice of semiconductor material and said metallic contact disk (5) are mounted in a package of the press pack type comprising:
- a contacting disk (7) of silver plated copper in contact with the first surface of the slice (6),
- two molybdenum or tungsten plates (3,4) overlying respectively the metallic disk (5) and the contacting disk (7),
- a porcelain body (12) forming the container of said slice, metallic contact disk, contacting disk and molybdenum or tungsten plates,
- a plastic washer (11) provided on the peripheral side of the slice to ensure its positioning in the container,
- an insulated metallic wire (14) for lead-in of the control current with the control terminal end thereof, consisting of a spiral spring in contact with the common control terminal of the slice through the opening of the metallic contact disk (5) facing said common control terminal of the slice,
- two or more nickel plated copper flanges (8,9,10) closing the porcelain body (12), and
- two nickel plated copper plates (1,2) each overlying one of the aforesaid flanges (8,9,10) and constituting the cathode and the anode of the package device.

11. A process for manufacturing an assembly of a power semiconductor device comprising an array of semiconductor component elements connected in parallel and a metallic contact disk, said process comprising the steps of:
- forming an array of semiconductor component elements in a slice of semiconductor material, each said component element having an anode electrode, a cathode electrode and a control electrode,
- forming a metallic layer covering said first surface, said metallic layer being formed on said anode electrodes of the semiconductor component elements,
- forming an array of discrete cathode metallizations on said second surface, each one being formed on a respective cathode electrode of a component element;
- forming a first series of metallic tracks on said second surface, each track of said first series of metallic tracks running around the periphery of a respective cathode metallization whilst being insulated therefrom and in contact with the control electrode of the respective component element,
- forming a second series of interconnected metallic tracks on said second surface and having vertical and horizontal tracks in a mesh-like lattice interconnected at each crossing and arranged such that inside each mesh of said lattice is a respective discrete cathode metallization and the corresponding track of said first series of metallic tracks,
- forming a common control terminal metallization area (31) in the centre of the second surface of the slice, said second series of interconnected metallic tracks being electrically connected to said common control terminal metallization area,
- forming for each semiconductor component element at least one fusible connection element (61, 62) associated therewith, said fusible connection element (61, 62) being formed on the second surface of the slice and connecting the respective track of said first series of metallic tracks with the respective adjacent track of said second series of interconnected metallic tracks ;
- providing a metallic contact disk (5) overlying the second surface of the slice for its entire extension, said metallic contact disk having an opening to face the said common control terminal metallization area (31) and also having on the surface contacting the slice a series of grooves corresponding to said first and second series of tracks so as to give an array of quadrangular relief portions, one for each semiconductor component element of the slice, and each one contacting the corresponding cathode metallization of one said component element,
- performing an acceptance test of the slice to identify any defective component elements,
- elimination by fusing of the fusible connection elements (61, 62) corresponding to the defective component elements, thereby electrically isolating said defective component elements from said common control terminal metallization area (31),
- elimination of ones of said relief portions intended for contacting the corresponding cathode metallization of said defective elementary components, and the optional replacement of said ones of said relief portions by a layer of insulating material.

12. Process for manufacturing a power semiconductor device according to claim 1 characterized in that the relief portions intended for contacting the corresponding cathode metallizations of said defective component elements are eliminated by removal with a step cutter.

13. Process according to claim 11, wherein the steps of elimination of ones of said relief portions intended for contacting the corresponding cathode metallization of said defective component elements and the optional replacement of said ones of said relief portions by a layer of insulating material, are replaced by the step of covering the cathode metallization of said defective component elements with a layer of insulating material.

14. Process according to claim 11 or 13 characterized in that said fusible connection elements are provided in the form of thin metallic tracks on the second surface of the slice.

15. Process according to claim 11 or 13 characterized in that said first series of metallic tracks and said second series of interconnected metallic tracks are provided with widened areas at the connection points with said fusible connection elements.

16. Process according to claim 15 characterized in that said elimination of the fusible connection elements is performed by passing in said fusible connection elements a current sufficiently strong to cause fusion, the fusion current being brought to a fusible connection element by two electrodes placed in contact with said widened areas.

17. Process for manufacturing a packaged power semiconductor device comprising the assembly according to claim 11, 12 or 13, wherein said assembly is mounted in a package of the press pack type, said package comprising the steps of:
- placing a contacting disk (7) of silver plated copper in contact with the first surface of the slice (6),
- overlaying two molybdenum or tungsten plates (3,4) respectively on the metallic contact disk (5) and the contacting disk (7),
- providing a porcelain body (12) as a container of said slice (6), metallic contact disk (5), contacting disk (6) and molybdenum or tungsten plates (3,4),
- inserting a plastic washer (11) on the peripheral side of the slice to ensure its positioning in the container (12),
- providing an insulated metallic wire (14) for lead-in of the control current, with a control terminal end thereof consisting of a spiral spring, said spring being placed in contact with the common control terminal (31) through the opening in the metallic contact disk (5) facing said common control terminal (31),
- providing two or more nickel plated copper flanges (8, 9,10) to close the porcelain body with welding performed in a pure nitrogen environment,
- overlaying two nickel plated copper plates (12) each on one of said flanges (8,9,10), said nickel plated copper plates constituting the cathode and the anode of the packaged device.

## Patentansprüche

1. Halbleiteranordnung für Leistungsbetrieb mit:
- einer Anordnung von Halbleiterbauelementen, die parallelgeschaltet sind und auf einer einzigen Scheibe aus Halbleitermaterial gebildet sind, welche eine erste und eine zweite Hauptoberfläche hat, wobei jedes dieser Halbleiterbauelemente eine Anodenelektrode, eine Kathodenelektrode und eine Steuerelektrode hat;
- einer die genannte erste Oberfläche bedeckenden Metallschicht, die auf den Anodenelektroden der Halbleiterbauelemente gebildet ist;
- einer auf den genannten zweiten Oberflächen befindliche Anordnung diskreter Kathodenmetallisierungen, deren jede auf einer jeweils zugehörigen Kathodenelektrode eines Bauelementes gebildet ist;
- einer auf der zweiten Oberfläche gebildetete ersten Gruppe metallischer Bahnen, deren jede um den Rand einer jeweils zugeordneten Kathodenmetallisierung läuft, aber davon isoliert ist und sich in Kontakt mit der Steuerelektrode des betreffenden Bauelementes befindet;
- einer auf der zweiten Oberfläche befindliche zweite Gruppe miteinander verbundener metallischer Bahnen, wobei vertikale und horizontale Exemplare der Bahnen ein netzartiges Gitter bilden und an jeder Kreuzung miteinander verbunden sind und derart angeordnet sind, daß innerhalb jeder Masche des Gitters eine jeweils zugeordnete diskrete Kathodenmetallisierung und die zugeordnete Bahn der ersten Gruppe metallischer Bahnen liegen,
- einer gemeinsamen Steueranschluß-Metallisierungsfläche (31) in der Mitte der zweiten Oberfläche der Scheibe, wobei die zweite Gruppe miteinander verbundener metallischer Bahnen elektrisch mit dieser gemeinsamen Steueranschluß-Metallisierungsfläche verbunden ist,
wobei jedes Halbleiterbauelement mindestens ein ihm zugeordnetes schmelzbares Verbindungselement (61, 62) hat, welches auf der zweiten Oberfläche der Scheibe vorgesehen ist und die zugeordnete Bahn der ersten Gruppe von Metallisierungsbahnen mit der jeweils benachbaren Bahn der zweiten Gruppe miteinander verbundener metallischer Bahnen verbindet.

2. Halbleiteranordnung für Leistungsbetrieb nach Anspruch 1, dadurch gekennzeichnet, daß die metallischen Bahnen der ersten Gruppe und die miteinander verbundenen metallischen Bahnen der zweiten Gruppe verbreiterte Bereiche an ihren Verbindungspunkten mit den schmelzbaren Verbindungselementen (61, 62) haben.

3. Halbleiteranordnung für Leistungsbetrieb nach Anspruch 1, dadurch gekennzeichnet, daß die schmelzbaren Verbindungselemente (61, 62) aus dünnen metallischen Bahnen auf der zweiten Oberfläche der Scheibe bestehen.

4. Halbleiteranordnung für Leistungsbetrieb nach Anspruch 1, dadurch gekennzeichnet, daß sie schadhafte Bauelemente (32) aufweist und daß an jedem schadhaften Bauelement die metallischen Bahnen der ersten Gruppe vollständig von den miteinander verbundenen metallischen Bahnen der zweiten Gruppe isoliert sind.

5. Baueinheit, zusammengestellt aus einer Halbleiteranordnung für Leistungsbetrieb nach Anspruch 1 und einer metallenen Kontaktscheibe, gekennzeichnet durch eine die zweite Oberfläche der Halbleiterscheibe über ihre gesamte Ausdehnung kontaktierende metallische Kontaktscheibe, die eine der gemeinsamen Steueranschluß-Metallisierungsfläche der Halbleiterscheibe gegenüberliegende Öffnung hat und außerdem auf der die Halbleiterscheibe kontaktierenden Oberflälche eine Gruppe von Nuten entsprechend der ersten und der zweiten Gruppe von Bahnen hat, derart, daß sich eine Anordnung viereckiger Reliefblöcke ergibt, jeweils einer für jedes wirksame Halbleiterbauelement der Halbleiterscheibe, deren jeder die entsprechende Kathodenmetallisierung eines der Bauelemente kontaktiert.

6. Baueinheit nach Anspruch 5, dadurch gekennzeichnet, daß gegenüberliegend jedem schadhaften Bauelement (32) der Halbleiterscheibe der jeweils betreffende Reliefblock fehlt.

7. Baueinheit nach Anspruch 6, dadurch gekennzeichnet, daß an jedem schadhaften Bauelement der Halbleiterscheibe die Kathodenmetallisierung von der benachbarten metallenen Kontaktscheibe (5) durch eine Schicht aus Isoliermaterial isoliert ist.

8. Baueinheit nach Anspruch 7, dadurch gekennzeichnet, daß die Isoliermaterialschicht aus Glimmer besteht.

9. Baueinheit nach Anspruvh 5, dadurch gekennzeichnet, daß die metallene Kontaktscheibe (5) versilbertes Kupfer oder Silber oder Molybdän ist.

10. Verkapselte Halbleiteranordnung für Leistungsbetrieb, welche die Baueinheit nach Anspruch 5 oder 9 aufweist, dadurch gekennzeichnet, daß die Scheibe aus Halbleitermaterial und die metallene Kontaktscheibe (5) in einer Verkapselung vom Press-Pack-Typ angeordnet sind, welche folgendes aufweist:
- eine kontaktierende Platte (7) aus versilbertem Kupfer in Kontakt mit der ersten Oberfläche der Halbleiterscheibe (6);
- zwei Molybdän- oder Wolframplatten (3, 4), die über der metallenen Scheibe (5) bzw. der kontaktierenden Platte (7) liegen;
- einen Porzellankörper (12), der den Behälter der Halbleiterscheibe, der metallenen Kontaktscheibe, der kontaktierenden Platte und der Molybdän- oder Wolframplatten bildet;
- einen Kunststoffring (11), der am Umfangsrand der Halbleiterscheibe vorgesehen ist, um deren Positionierung im Behälter zu gewährleisten;
- einen zur Einleitung des Steuerstroms dienenden isolierten Metalldraht (14), dessen Steueranschlußende aus einer Spiralfeder besteht, die durch die dem gemeinsamen Steueranschluß der Halbleiterscheibe gegenüberliegenden Öffnung der metallenen Kontaktscheibe (5) in Kontakt mit dem gemeinsamen Steueranschluß der Halbleiterscheibe steht;
- zwei oder mehr vernickelte Kupferflansche (8, 9, 10), die den Porzellankörper (12) verschließen, und
- zwei vernickelte Kupferplatten (1, 2), deren jede über jeweils einem der vorstehend genannten Flansche (8, 9, 10) liegt und welche die Kathode und die Anode der Kapseleinrichtung bilden.

11. Verfahren zur Herstellung einer Baueinheit einer Halbleiteranordnung für Leistungsbetrieb, die eine Anordnung parallelgeschalteter Halbleiterbauelemente enthält, und einer metallenen Kontaktscheibe, mit folgenden Schritten:
- Bildung einer Anordnung von Halbleiterbauelementen in einer Scheibe aus Halbleitermaterial, wobei jedes der Bauelemente eine Anodenelektrode, eine Kathodenelektrode und eine Steuerelektrode hat;
- Bildung einer Metallschicht, welche die erste Oberfläche bedeckt und auf den Anodenelektroden der Halbleiterbauelemente gebildet ist;
- Bildung einer Anordnung diskreter Kathodenmetallisierungen auf der zweiten Oberfläche, deren jede auf einer jeweiligen Kathodenelektrode eines Bauelementes gebildet ist;
- Bildung einer ersten Gruppe metallischer Bahnen auf der zweiten Oberfläche, wobei jede dieser Bahnen um den Umfang einer jeweils zugeordneten Kathodenmetallisierung läuft, aber davon isoliert ist und in Kontakt mit der Steuerelektrode des betreffenden Bauelementes steht;
- Bildung einer zweiten Gruppe miteinander verbundener metallischer Bahnen auf der zweiten Oberfläche, wobei vertikale und horizontale Exemplare dieser Bahnen ein netzartiges Gitter bilden und an jedem Kreuzungspunkt miteinander verbunden sind und derart angeordnet sind, daß innerhalb jeder Masche dieses Gitters eine jeweils zugeordnete diskrete Kathodenmetallisierung und die entsprechende Bahn der ersten Gruppe metallischer Bahnen liegt;
- Bildung einer gemeinsamen Steueranschluß-Metallisierungsfläche (31) in der Mitte der zweiten Oberfläche der Halbleiterscheibe, wobei die zweite Gruppe miteinander verbundener metallischer Bahnen mit der gemeinsamen Steueranschluß-Metallisierungsfläche elektrisch verbunden ist;
- Bildung mindestens eines schmelzbaren Verbindungselementes (61, 62) für jedes Halbleiterbauelement und diesem zugeordnet, wobei das schmelzbare Verbindungselement (61, 62) auf der zweiten Oberfläche der Halbleiterscheibe gebildet ist und die jeweilige Bahn der ersten Gruppe metallischer Bahnen mit der jeweils benachbarten Bahn der zweiten Gruppe miteinander verbundener metallischer Bahnen verbindet;
- Vorsehen einer metallenen Kontaktscheibe (5), welche über der zweiten Oberfläche der Halbleiterscheibe über deren gesamte Ausdehnung liegt und eine Öffnung gegenüber der gemeinsamen Steueranschluß-Metallisierungsfläche (31) hat und außerdem auf der die Halbleiterscheibe kontaktierenden Oberfläche eine Gruppe von Nuten hat, die der ersten und der zweiten Gruppe von Bahnen entsprechen, so daß sich eine Anordnung viereckiger Reliefblöcke ergibt, einer für jedes Halbleiterbauelement der Halbleiterscheibe, und deren jeder die jeweils zugeordnete Kathodenmetallisierung eines der Bauelemente kontaktiert;
- Durchführung einer Abnahmeprüfung der Halbleiterscheibe zur Identifizierung irgendwelcher schadhafter Bauelemente;
- durch Schmelzen herbeigeführte Eliminierung der schmelzbaren Verbindungselemente (61, 62), welche den schadhaften Bauelementen entsprechen, und dadurch elektrische Trennung der schadhaften Bauelemente von der gemeinsamen Steueranschluß-Metallisierungsfläche (31);
- Eliminierung derjenigen Exemplare der Reliefblöcke, die zur Kontaktierung der entsprechenden Kathodenmetallisierung des schadhaften Bauelementes gedacht sind, und wahlfrei ein Ersatz dieser Exemplare der Reliefblöcke durch eine Schicht aus Isoliermaterial.

12. Verfahren zur Herstellung einer Halbleiteranordnung für Leistungsbetrieb nach Anspruch 1, dadurch gekennzeichnet, daß die Reliefblöcke, die zur Kontaktierung der entsprechenden Kathodenmetallisierungen der schadhaften Bauelemente gedacht sind, durch Entfernen mittels eines Stufenschneidgerätes eliminiert werden.

13. Verfahren nach Anspruch 11, wobei die Schritte zur Eliminierung von Exemplaren derjenigen Reliefblöcke, die zur Kontaktierung der entsprechenden Kathodenmetallisierung der schadhaften Bauelemente und den wahlfreien Austausch durch eine Schicht aus Isoliermaterial gedacht sind, ersetzt werden durch den Schritt eines Beschichtens der Kathodenmetallisierung des schadhaften Bauelementes mit einer Schicht aus Isoliermaterial.

14. Verfahren nach Anspruch 11 oder 13, dadurch gekennzeichnet, daß die schmelzbaren Verbindungselemente in Form dünner metallischer Bahnen auf der zweiten Oberfläche der Halbleiterscheibe vorgesehen werden.

15. Verfahren nach Anspruch 11 oder 13, dadurch gekennzeichnet, daß die metallischen Bahnen der ersten Gruppe und die miteinander verbundenen Bahnen der zweiten Gruppe mit verbreiterten Flächen an den Verbindungspunkten zu den schmelzbaren Verbindungselementen ausgestattet werden.

16. Verfahren nach Anspruch 15, dadurch gekennzeichnet, daß die Eliminierung der schmelzbaren Verbindungselemente durchgeführt wird, indem durch die schmelzbaren Verbindungselemente ein zum Schmelzen genügend starker Strom geleitet wird, wobei das Anlegen des Schmelzstroms an ein schmelzbares Verbindungselement durch zwei Elektroden erfolgt, die in Kontakt mit den genannten verbreiterten Flächen gebracht werden.

17. Verfahren zur Herstellung einer verkapselten Halbleiteranordnung für Leistungsbetrieb, welche die Baueinheit nach Anspruch 11, 12 oder 13 enthält, wobei diese Baueinheit in einer Verkapselung vom Press-Pack-Typ durch folgende Schritte untergebracht wird:
- eine kontaktierende Platte (7) aus versilbertem Kupfer wird in Kontakt mit der ersten Oberfläche der Halbleiterscheibe (6) gebracht;
- zwei Molybdän- oder Wolframplatten (3, 4) werden über die metallene Kontaktscheibe (5) bzw. die kontaktierende Platte (7) gelegt;
- als ein Behälter für die Halbleiterscheibe (6), die metallene Kontaktscheibe (5), die kontaktierende Platte (6) und die Molybdän- oder Wolframplatten (3, 4) wird ein Porzellankörper (12) vorgesehen;
- ein Kunststoffring (11) wird auf den Umfangsrand der Halbleiterscheibe gesetzt, um deren Positionierung im Behälter (12) zu sichern;
- zum Einleiten von Steuerstrom wird ein isolierter Metalldraht (14) vorgesehen, der ein aus einer Spiralfeder bestehendes Steueranschlußende hat, wobei die Feder durch die dem gemeinsamen Steueranschluß (31) gegenüberliegende Öffnung in der metallenen Kontaktscheibe (5) in Kontakt mit dem gemeinsamen Steueranschluß (31) gebracht wird;
- es werden zwei oder mehr vernickelte Kupferflansche (8, 9, 10) vorgesehen, um den Porzellankörper durch Schweißen in einer reinen Stickstoffatmosphäre zu verschließen;
- es werden zwei vernickelte Kupferplatten (12) darübergelegt, jeweils eine auf jeden der Flansche (8, 9, 10), wobei diese vernickelten Kupferplatten die Kathode und die Anode der verkapselten Einrichtung bilden.

## Revendications

1. Dispositif semiconducteur de puissance comprenant :
- un réseau de composants semiconducteurs élémentaires connectés en parallèle et formés dans une unique tranche de matériau semiconducteur ayant une première et une seconde face principale, chacun de ces composants ayant une électrode d'anode, une électrode de cathode et une électrode de commande,
- une couche métallique couvrant la première face, cette couche métallique étant formée sur les électrodes d'anode des composants semiconducteurs,
- un réseau de métallisations discrètes de cathode sur les secondes faces, chacune étant formée sur une électrode de cathode respective d'un composant élémentaire,
- une première série de pistes métalliques sur la seconde face, chaque piste de chaque première série de pistes métalliques passant autour de la périphérie d'une métallisation de cathode respective tout en étant isolée de celle-ci et en contact avec l'électrode de commande du composant respectif,
- une seconde série de pistes métalliques interconnectées sur la seconde face et ayant des pistes verticale et horizontale en un réseau maillé interconnecté à chaque croisement et disposé de telle sorte qu'à l'intérieur de chaque maille dudit réseau se trouve une métallisation de cathode respective discrète et la piste correspondante de la première série de pistes métalliques,
- une zone de métallisation de borne de commande commune (31) au centre de la seconde face de la tranche, la seconde série de pistes métalliques interconnectées étant électriquement connectée à cette zone de métallisation de borne de commande commune,
chaque composant semiconducteur élémentaire étant associé à au moins un élément de connexion fusible (61, 62), cet élément de connexion fusible (61, 62) étant formé sur la seconde face de la tranche et reliant la piste respective de la première série de pistes métalliques à la piste respective adjacente de la seconde série de pistes métalliques interconnectées.

2. Dispositif semiconducteur de puissance selon la revendication 1, caractérisé en ce que la première série de pistes métalliques et la seconde série de pistes métalliques interconnectées ont des zones élargies au point de connexion avec les éléments de connexion fusibles (61, 62).

3. Dispositif semiconducteur de puissance selon la revendication 1, caractérisé en ce que les éléments de connexion fusibles (61, 62) consistent en des pistes métalliques minces sur la seconde face de la tranche.

4. Dispositif semiconducteur de puissance selon la revendication 1, caractérisé en ce que le dispositif comprend des composants défectueux (32) et que à chaque composant défectueux la première série de pistes métalliques est complètement isolée de la seconde série de pistes métalliques interconnectées.

5. Assemblage d'un dispositif semiconducteur de puissance selon la revendication 1 et d'un disque métallique de contact, caractérisé par un disque métallique de contact (5) en contact avec la seconde face de la tranche dans toute son extension, ayant une ouverture faisant face à la zone de métallisation de borne de commande commune de la tranche et ayant également sur la face en contact avec la tranche une série de rainures correspondant aux première et seconde séries de pistes de façon à former un réseau de parties quadrangulaires en relief, une pour chaque composant semiconducteur efficace de la tranche, chacune étant en contact avec la métallisation de cathode correspondante d'un composant.

6. Assemblage selon la revendication 5, caractérisé en ce que, en face de chaque composant défectueux (32) de la tranche, les parties quadrangulaires en relief manquent.

7. Assemblage selon la revendication 6, caractérisé en ce que, au niveau de chaque composant défectueux de la tranche, la métallisation de cathode est isolée du disque métallique de contact voisin (5) par une couche de matériau isolant.

8. Assemblage selon la revendication 7, caractérisé en ce que la couche de matériau isolant consiste en du mica.

9. Assemblage selon la revendication 5, caractérisé en ce que le disque métallique de contact (5) est en cuivre revêtu d'argent, en argent ou en molybdène.

10. Dispositif de puissance à semiconducteur dans son boîtier comprenant l'assemblage de la revendication 5 ou 9, caractérisé en ce que la tranche de matériau semiconducteur et le disque métallique de contact (5) sont montés dans un boîtier du type press pack comprenant :
- un disque de contact (7) en cuivre revêtu d'argent en contact avec la première face de la tranche (6),
- deux plaques de molybdène ou de tungstène (3, 4) recouvrant respectivement le disque métallique (5) et le disque de contact (7),
- un corps de porcelaine (12) formant le réceptacle de la tranche, du disque métallique de contact, du disque de contact et des plaques de molybdène ou de tungstène,
- une rondelle de plastique (11) disposée sur la partie périphérique de la tranche pour assurer son positionnement dans le réceptacle,
- un fil métallique isolé (14) pour l'amenée du courant de commande dont l'extrémité de borne de commande consiste en un ressort spiral en contact avec la borne de commande commune de la tranche à travers une ouverture du disque métallique de contact (5) faisant face à la borne de commande commune de la tranche,
- deux flasques de cuivre revêtu de nickel, ou plus, (8, 9, 10) fermant le corps de porcelaine (12), et
- deux plaques de cuivre revêtu de nickel (1, 2), chacune recouvrant l'un des flasques (8, 9, 10) et constituant la cathode et l'anode du boîtier.

11. Procédé de fabrication d'un assemblage d'un dispositif de puissance à semiconducteur comprenant un réseau de composants semiconducteurs connectés en parallèle et un disque de contact métallique, ce procédé comprenant les étapes suivantes :
- formation d'un réseau de composants semiconducteurs dans une tranche de matériau semiconducteur, chacun des composants ayant une électrode d'anode, une électrode de cathode et une électrode de commande,
- formation d'une couche métallique couvrant la première face, cette couche métallique étant formée sur les électrodes d'anode des composants semiconducteurs,
- formation d'un réseau de métallisations discrètes de cathode sur la seconde face, chacune étant formée sur une électrode de cathode respective d'un composant élémentaire,
- formation d'une première série de pistes métalliques sur la seconde face, chaque piste de la première série de pistes métalliques passant autour de la périphérie d'une métallisation de cathode respective tout en étant isolée de celle-ci et en contact avec l'électrode de commande du composant respectif,
- formation d'une seconde série de pistes métalliques interconnectées sur la seconde face et comportant des pistes verticales et horizontales en un réseau maillé interconnecté à chaque croisement et disposé de telle sorte qu'à l'intérieur de chaque maille du réseau se trouve une métallisation de cathode discrète respective et la piste correspondante de la première série de pistes métalliques,
- formation d'une zone de métallisation de borne de commande commune (31) au centre de la seconde face de la tranche, la seconde série de pistes métalliques interconnectées étant électriquement connectée à la zone de métallisation de borne de commande commune,
- formation pour chaque composant semiconducteur d'au moins un élément de connexion fusible (61, 62) associé à celui-ci, l'élément de connexion fusible (61, 62) étant formé sur la seconde face de la tranche et connectant la piste respective de la première série de pistes métalliques à la piste respective adjacente de la seconde série de pistes métalliques interconnectées ;
- apport d'un disque de contact métallique (5) recouvrant la seconde face de la tranche sur toute son extension, ce disque métallique de contact disposant d'une ouverture pour faire face à la zone de métallisation de borne de commande commune (31) et comportant également sur sa face en contact avec la tranche une série de rainures correspondant aux première et seconde séries de pistes de façon à former un réseau de parties en relief quadrangulaire, une pour chaque composant semiconducteur de la tranche, et chacune étant en contact avec la métallisation de cathode correspondante d'un composant,
- réalisation d'un test d'acceptation de la tranche pour identifier tout composant défectueux,
- élimination par fusion des éléments de connexion fusibles (61, 62) correspondant aux composants défectueux, isolant de ce fait les composants défectueux de la zone de métallisation de borne de commande commune (31), et
- élimination d'une des parties en relief conçues pour entrer en contact avec les métallisations de cathode correspondantes des composants élémentaires défectueux, et remplacement optionnel de ces parties en relief par une couche de matériau isolant.

12. Procédé de fabrication d'un dispositif de puissance à semiconducteur selon la revendication 1, caractérisé en ce que les parties en relief conçues pour entrer en contact avec les métallisations de cathode correspondantes des composants défectueux sont éliminées par enlèvement à l'aide d'un outil de coupe.

13. Procédé selon la revendication 11, dans lequel les étapes d'élimination des parties en relief conçues pour entrer en contact avec les métallisations de cathode des composants défectueux et de remplacement optionnel de ces parties en relief par une couche de matériau isolant, sont remplacées par l'étape de couverture de la métallisation de cathode des composants défectueux par une couche de matériau isolant.

14. Procédé selon la revendication 11 ou 13, caractérisé en ce que les éléments de connexion fusibles sont fournis sous la forme de pistes métalliques minces sur la seconde face de la tranche.

15. Procédé selon la revendication 11 ou 13, caractérisé en ce que la première série de pistes métalliques et la deuxième série de pistes métalliques interconnectées sont munies de zones élargies aux points de connexion avec les éléments de connexion fusibles.

16. Procédé selon la revendication 15, caractérisé en ce que l'élimination des éléments de connexion fusibles est réalisée par le passage dans ces éléments de connexion fusible d'un courant suffisant pour provoquer la fusion, le courant de fusion étant amené à l'élément de connexion fusible par deux électrodes placées en contact avec les zones élargies.

17. Procédé de fabrication d'un dispositif de puissance à semiconducteur dans son boîtier comprenant l'assemblage selon la revendication 11, 12 ou 13 dans lequel ledit assemblage est monté dans un boîtier du type press pack, cette opération comprenant les étapes suivantes :
- placement d'un disque de contact (7) de cuivre revêtu d'argent en contact avec la première face de la tranche (6),
- recouvrement du disque métallique de contact (5) et du disque de contact (7) par deux plaques de molybdène ou de tungstène (3, 4), respectivement,
- apport d'un corps de porcelaine (12) en tant que réceptacle de la tranche (6), du disque métallique de contact (5), du disque de contact (6) et des plaques de molybdène ou de tungstène (3, 4),
- insertion d'une rondelle de plastique (11) sur la partie périphérique de la tranche pour assurer son positionnement dans le réceptacle (12),
- apport d'un fil métallique isolé (14) pour l'amenée du courant de commande, dont l'extrémité de borne de commande consiste en un ressort spiral, ce ressort étant placé en contact avec la borne de commande commune (31) à travers l'ouverture du disque métallique de contact (5) faisant face à la borne de commande commune (31),
- apport de deux flasques de cuivre revêtu de nickel ou plus (8, 9, 10) pour fermer le corps de porcelaine par un soudage réalisé dans un environnement d'azote pur,
- recouvrement de chacun des flasques (8, 9, 10) par une plaque de cuivre revêtu de nickel (12), ces plaques de cuivre revêtu de nickel constituant la cathode et l'anode du dispositif dans son boîtier.
